Europäisches Patentamt

European Patent Office

Office européen des brevets

(19)

(11) Veröffentlichungsnummer: **0 143 957**
**B1**

# (12) EUROPÄISCHE PATENTSCHRIFT

(45) Veröffentlichungstag der Patentschrift:
27.01.88

(51) Int. Cl.⁴: **H 01 L 33/00, H 01 L 21/208**

(21) Anmeldenummer: **84112411.8**

(22) Anmeldetag: **15.10.84**

(54) Verfahren zur Herstellung von A3B5-Lumineszenzdioden.

(30) Priorität: **28.10.83 DE 3339272**

(43) Veröffentlichungstag der Anmeldung:
**12.06.85 Patentblatt 85/24**

(45) Bekanntmachung des Hinweises auf die Patenterteilung:
**27.01.88 Patentblatt 88/4**

(84) Benannte Vertragsstaaten:
**AT CH DE FR GB LI NL**

(56) Entgegenhaltungen:
**US - A - 4 342 148**

**JOURNAL OF APPLIED PHYSICS, Band 48, Nr. 6, Juni 1977, Seiten 2485-2493, American Institute of Physics, New York, US; L.R. DAWSON: "High-efficiency graded-band-gap Ga1-xAlxAs light-emitting diodes"**

(73) Patentinhaber: **Siemens Aktiengesellschaft Berlin und München, Wittelsbacherplatz 2, D-8000 München 2 (DE)**

(72) Erfinder: **Leibenzeder, Siegfried, Strassberg 19, D-8520 Erlangen (DE)**
Erfinder: **Heindl, Christine, Etzenrichter Strasse 39, D-8481 Mantel (DE)**

**Beschreibung**

Die Erfindung betrifft ein Verfahren zur Herstellung von $A_3B_5$-Lumineszenzdioden, insbesondere (Ga, Al) As-Lumineszenzdioden mit Te und Zn als Dotierstoffe durch Abscheidung von (Ga, Al) As aus n- und p-dotierten Ga, Al, As-Schmelzen über Flüssigphasenepitaxie.

Lumineszenzdioden sind Halbleiterdioden mit pn-Übergang, die bei Anlegen einer Spannung in Flussrichtung am pn-Übergang und in dessen unmittelbarer Umbebung ungerichtete, inkohärente elektromagnetische Strahlung im infraroten, sichtbaren oder ultravioletten Spektralbereich aussenden. Als Halbleitermaterial für diese Lumineszenzdioden sind insbesondere III-V-Verbindungen geeignet. Die Lumineszenzdioden sind für optoelektronische Anwendungen der verschiedensten Art geeignet. Beispielsweise kann mit ihrer Hilfe elektrische Energie in Lichtenergie umgewandelt werden und damit auf optischem Wege übertragen werden. Die Lichtleistung der Lumineszenzdioden soll möglichst gross sein.

Es ist bekannt, auf einem GaAs-Substrat durch Heteroepitaxieverfahren, bei dem zwei Mischkristallschichten mit unterschiedlichem Al-Gehalt und elektrischem Leitungstyp aus zwei Ga, Al, As-Schmelzen in zwei getrennten Epitaxieschritten auf einem GaAs-Substrat abgeschieden werden (IEEE Transactions on Electron Devices, Vol. ED-28. No. 4. April 1981). Die mehrfach notwendige Epitaxie für Heterostrukturen mit relativ kompliziertem Aufbau erfordert mehrere Al-haltige Ga-Schmelzen und einen relativ hohen technischen und technologischen Aufwand. Ferner sind zur Gewährleistung eines konstanten Al-Gehaltes in der Mischkristallschicht mit einer Dicke von z. B. 20 µm bis 30 µm relativ dicke Ga, Al, As-Schmelzen erforderlich.

Ferner ist ein Verfahren bekannt, bei dem der Al-Gehalt mit zunehmendem Schichtwachstum kontinuierlich abnimmt. Dieses Verfahren ist unter dem Namen «graded-band-gap-Verfahren» bekannt und beispielsweise in «Journal of Applied Physics, Vol. 48, No. 6. June 1977» beschrieben. Der bandkantennahe Einbau, der beispielsweise bei Te vorliegt, bedingt hohe Absorptionsverluste des am pn-Übergang entstehenden Lichtes verbunden mit einer geringen Lichtausbeute.

Aufgabe der Erfindung ist es daher, ein Verfahren zur Herstellung vom Lumineszenzdioden (LED: Light Emitting Diodes) zu entwickeln mit hoher Effizienz. Für den sichtbaren Spektralbereich mit einer peak-Emissionswellenlänge λ von 620 nm bis 700 nm auf der Basis von (Ga, Al) As. Es sollen mit Hilfe der Flüssigphasenepitaxie (LPE: Liquid Phase Epitaxy) lichtaktive $Ga_{1-x}Al_xAs$-Schichten auf GaAs-Substraten abgeschieden werden.

Diese Aufgabe wird dadurch gelöst, das erfindungsgemäss auf ein GaAs-Substrat aus einer mit S, Se oder Te n-dotierten Ga, Al, As-Schmelze eine erste n-GaAlAs-Schicht epitaxiert wird und nach einer Zwischenabscheidung ohne Kontakt mit dem GaAs-Substrat auf dem mit der n-GaAlAs-Schicht epitaxierten Substrat eine mit Zn oder Mg p-dotierte GaAlAs-Schicht epitaxiert wird. Es können so Lumineszenzdioden mit hoher Effizienz erhalten werden. Ein Hilfssubstrat hat sich für die Zwischenabscheidung besonders bewährt.

Erfindungsgemäss erfolgt die GaAlAs-Abscheidung mit einem graded bandgap aus einer S-, Se- oder Te-dotierten Ga, Al, As-Schmelze, wobei durch Umdotierung der Ga, Al, As-Schmelze mit Zn oder Mg über die Gasphase auf der zuerst abgeschiedenen und dotierten (Ga, Al) As-Epitaxieschicht die p-GaAlAs-Schicht wächst und somit der pn-Übergang gebildet wird.

Das erfindungsgemässe Verfahren soll weiterhin als «stepgrading-Verfahren» bezeichnet werden.

Zur Verhinderung der Absorptionsverluste, bedingt durch den bandkantennahen Einbau des S, Se oder Te, ist es zweckmässig, das graded bandgap zumindest im Bereich des pn-Überganges genügend steil zu halten. Die Steilheit des graded bandgap kann über einen höheren Al-Gehalt der Ga, Al,As-Schmelze und/oder durch eine höhere Abkühlrate, vorzugsweise mit einer Abkühlrate von 0,5 bis 5 K/min der Schmelze erreicht werden.

Durch das erfindungsgemässe stepgrading-Verfahren wird eine abrupte Änderung der Al-Konzentration zwischen n- und p- (Ga, Al) As-Schicht, d. h. im Bereich des pn-Überganges erreicht, womit eine Steigerung der Elektroneninjektion von der n-Schicht in das effizientere p-Gebiet zu erzielen ist. Die Strahlungsintensität der Dioden wird dadurch erhöht.

Eine abrupte Änderung ist zwar auch bei Heteroepitaxieverfahren über den unterschiedlichen Al-Gehalt von zwei Schmelzen zu realisieren. Von Nachteil ist jedoch der höhere Aufwand der Verfahren. Erfindungsgemäss ist dagegen für die abrupte Änderung der Mischkristallzusammensetzung zwischen n- und p-Schicht nur eine Ga, Al, As-Schmelze notwendig.

Im Gegensatz zu Heterostrukturen, wobei die Mischkristallzusammensetzung in der jeweiligen Epitaxieschicht konstant ist, steigt der Al-Gehalt bei dem erfindungsgemässen Verfahren vor allem in der n-Schicht in Abstrahlrichtung an, woraus eine bessere Lichtauskopplung resultiert.

Die nach dem erfindungsgemässen Verfahren erhaltenen Lumineszenzdioden eignen sich vor allem für den sichtbaren Spektralbereich für Indikatorlampen, Siebensegment Displays oder alphanumerischen Anzeigen in Fernsprech-, Daten- und Signalanlagen und Geräten der Konsumelektronik.

Weitere Einzelheiten der Erfindung sind anhand des in Fig. 1 gezeigten Ausführungsbeispiels und der Figuren 2 und 3 erläutert.

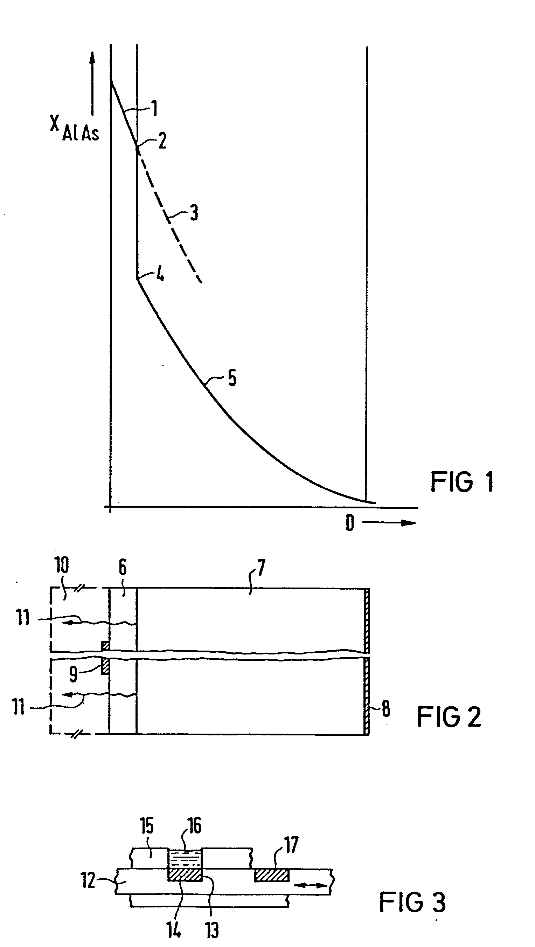

In Fig. 1 ist der Verlauf des Wachstums der GaAlAs-Schichten in Abhängigkeit von der Schichtdicke D dargestellt. Nach dem Wachstum der n-GaAlAs-Schicht, deren Dicke durch den Zeitpunkt der Schmelzentrennung vom Hauptsubstrat in Punkt 2 bestimmt wird, wobei Zeitpunkt und demnach Schichtdicke und Emissionswellenlänge variabel sind, erfolgt die weitere Schichtabschei-

dung mit abnehmenden Al-Gehalt des Mischkristalles auf einem Nebensubstrat 3. Während 3 wird das Zn verdampft und im Punkt 4 das Hauptsubstrat wieder mit der jetzt an Al verarmten Ga, Al, As-Schmelze in Kontakt gebracht. Die Ortsveränderung der Schmelzen bzw. Substrate kann mit einem Schiebe- oder Rotatorboot erfolgen. Im Bereich der abrupten Bandänderung wird demnach der pn-Übergang gebildet und im Bereich 5 wächst die Zn-dotierte (Ga, Al) As-Schicht.

In Fig. 2 ist mit 6 die n-leitende, mit 7 die p-leitende (Ga, Al) As-Schicht, mit 8 der p-Kontakt, mit 9 der n-Kontakt und mit 10 das GaAs-Substrat bezeichnet, das nach der Epitaxie zur besseren Lichtauskopplung entfernt wird. Die am pn-Übergang durch strahlende Rekombination erzeugten Photonen 11 können dann nahezu ohne Absorptionsverluste durch die n-Schicht 6, deren Al-Gehalt in Abstrahlrichtung zunimmt, austreten.

Fig. 3 zeigt eine Vorrichtung zur Durchführung der Erfindung.

In dem Ausführungsbeispiel wird die Erfindung anhand der Fig. 1 bis 3 näher erläutert.

Die Epitaxie erfolgt in einem horizontal angeordneten Graphitschiebeboot mit bekannter Ausführung.

Im Bootschieber 12 befindet sich eine Vertiefung 13 zur Aufnahme des GaAs-Substrats 14. Der Bootkasten 15 ist mit einer Kammer 16 ausgebildet, die zur Aufnahme der Al-haltigen Ga, As-Schmelze dient. Der Aluminiumatomzahlanteil $x^1_{Al}$ der Schmelze beträgt 4 bis $10 \times 10^{-3}$.

Das Boot befindet sich in einem $H_2$-durchströmten Quarzrohr und wird auf die Epitaxietemperatur von ca. 920° C hochgeheizt.

Nach dem Einstellen des thermodynamischen Gleichgewichts wird das GaAs-Substrat mit der Te-dotierten Ga, Al, As-Schmelze in Kontak gebracht und der Ofen abgekühlt, wobei es zum Schichtwachstum kommt. Nach dem Wachstum der Te-dotierten GaAlAs-Schicht 1 wird die Schmelze zum Zeitpunkt 2 vom GaAs-Substrat getrennt. Die weitere Abscheidung kann in der Schmelze oder auf einem Hilfssubstrat 17 erfolgen.

Während der Zeit 3, in der die Abscheidung in der Schmelze oder auf dem Hilfssubstrat erfolgt, wird Zn – das sich am Gaseinlass des Quarzrohres befindet, welcher separat beheizt wird – verdampft. Dadurch wird die n-dotierte Ga, Al, As-Schmelze kompensiert und schliesslich p-dotiert.

Im Punkt 4 wird das Substrat wieder mit der jetzt an Al-verarmten Ga, Al, As-Schmelze in Kontakt gebracht, wobei durch weitere Abkühlung die p-Schicht abgeschieden wird. Damit ist die Lage des pn-Überganges im Bereich des abrupten Bandüberganges festgelegt.

Durch den Zeitpunkt der Schmelzentrennung vom Substrat im Punkt 2 sind n-Schichtdicke und demnach wegen des abnehmenden Al-Gehaltes der Ga, As-Schmelze mit fortschreitendem Wachstum die Emissionswellenlänge variabel.

## Patentansprüche

1. Verfahren zur Herstellung von $A_3B_5$-Lumineszenzdioden, insbesondere (Ga, Al) As:Te, Zn-Lumineszenzdioden, durch Abscheidung von (Ga, Al) As aus n- und p-dotierten Ga, Al, As-Schmelzen über Flüssigphasenepitaxie, dadurch gekennzeichnet, dass auf ein GaAs-Substrat aus einer mit S, Se oder Te n-dotierten Ga, Al, As-Schmelze eine erste n-GaAlAs-Schicht epitaxiert wird und nach einer Zwischenabscheidung ohne Kontakt mit dem Ga As-Substrat auf dem mit der n-GaAlAs-Schicht epitaxierten Substrat eine mit Zn oder Mg p-dotierte GaAlAs-Schicht epitaxiert wird.

2. Verfahren nach Anspruch 1, dadurch gekennzeichnet, dass aus einer Ga, Al, As-Schmelze mit einem steilen graded bandgap abgeschieden wird.

3. Verfahren nach Anspruch 2, dadurch gekennzeichnet, dass der steilere Verlauf des graded bandgap durch einen höheren Aluminiumatomzahlanteil im Bereich von 4 bis $10 \times 10^{-3}$ der Ausgangsschmelze erreicht wird.

4. Verfahren nach Anspruch 2, dadurch gekennzeichnet, dass der steilere Verlauf des graded bandgap durch eine höhere Abkühlrate im Bereich von 0,5 bis 5 K/min$^{-1}$ der Schmelze erreicht wird.

5. Verfahren nach Anspruch 2, dadurch gekennzeichnet, dass auf eine Epitaxietemperatur von ca. 920° C erhitzt wird.

6. Verfahren nach Anspruch 1 bis 5, dadurch gekennzeichnet, dass die Zwischenabscheidung auf einem Hilfssubstrat erfolgt.

## Claims

1. A process for the production of $A_3B_5$-light emitting diodes, particularly but not exclusively, (Ga, Al) As:Te, Zn-light emitting diodes, by the deposition of (Ga, Al) As from n- and p-doped Ga, Al, As melts by liquid phase epitaxy, characterised in that a first n-GaAlAs layer is epitaxially grown on a GaAs substrate from a Ga, Al, As melt, which is n-doped with S, Se or Te, and after an intermediate deposition without contact with the Ga As substrate, a Ga Al As layer, which is p-doped with Zn or Mg, is epitaxially grown on the substrate upon which the n-GaAlAs layer was epitaxially grown.

2. A process as claimed in Claim 1, characterised in that the deposition takes place from a Ga, Al, As melt with a steep graded band-gap.

3. A process as claimed in Claim 2, characterised in that the steeper course of the graded band gap is achieved by a higher proportion of aluminium atoms in the starting melt, in the range of 4 to $10 \times 10^{-3}$.

4. A process as claimed in Claim 2, characterised in that the steeper course of the graded band gap is achieved by a higher cooling rate for the melt, in the range of 0.5 to 5 K/min$^{-1}$.

5. A process as claimed in Claim 2, characterised in that heating is effected to an epitaxial temperature of about 920° C.

6. A process as claimed in Claim 1 to 5, characterised in that the intermediate deposition takes place on an auxiliary substrate.

## Revendications

1. Procédé de fabrication de diodes électroluminescentes $A_3B_5$, notamment de diodes électroluminescentes (Ga, Al) As:Te, Zn, par dépôt par épitaxie en phase liquide de (Ga, Al) As, à partir de masses fondues de Ga, Al, As à dopage n et p, caractérisé en ce qu'il consiste à déposer, par épitaxie, une première couche de Ga, Al, As du type n sur un substrat en Ga, As, à partir d'une masse fondue de Ga, Al, As dopée du type n par S, Se ou Te et, après un dépôt intermédiaire sans contact avec le substrat en Ga, As, à déposer par épitaxie une couche de Ga Al As dopée du type p par Zn ou Mg, sur le substrat revêtu par épitaxie d'une couche de GaAlAs du type n.

2. Procédé suivant la revendication 1, caractérisé en ce qu'il consiste à effectuer le dépôt à partir d'une masse fondue de Ga, Al, As ayant une bande interdite à gradin de pente raide.

3. Procédé suivant la revendication 2, caractérisé en ce qu'il consiste à obtenir la courbe plus raide de la bande interdite à gradin, par une proportion en nombre d'atomes d'aluminium plus élevée, dans la plage allant de 4 à $10 \times 10^{-3}$, de la masse fondue de départ.

4. Procédé suivant la revendication 2, caractérisé en ce qu'il consiste à obtenir la courbe plus raide de la bande interdite à gradin par une plus grande vitesse de refroidissement, dans la plage de 0,5 à 5 K/minute $^{-1}$, de la masse fondue.

5. Procédé suivant la revendication 2, caractérisé en ce qu'il consiste à chauffer à une température d'épitaxie de 920° C environ.

6. Procédé suivant les revendications 1 à 5, caractérisé en ce qu'il consiste à effectuer le dépôt intermédiaire sur un substrat auxiliaire.

FIG 1

FIG 2

FIG 3